Europäisches Patentamt

European Patent Office

Office européen des brevets

(19)

(11) Publication number: **0 158 028**
**A2**

# (12) EUROPEAN PATENT APPLICATION

(21) Application number: **85101311.0**

(22) Date of filing: **07.02.85**

(51) Int. Cl.⁴: **G 11 C 7/00**

(30) Priority: **07.02.84 JP 35494/84**

(43) Date of publication of application:
**16.10.85 Bulletin 85/42**

(84) Designated Contracting States:
**DE FR GB**

(71) Applicant· **Kabushiki Kaisha Toshiba**
**72, Horikawa-cho Saiwai-ku**
**Kawasaki-shi Kanagawa-ken 210(JP)**

(72) Inventor: **Isobe, Mitsuo c/o Patent Division**
**Kabushiki Kaisha Toshiba 1-1 Shibaura 1-chome**
**Minato-ku Tokyo 105(JP)**

(74) Representative: **Henkel, Feiler, Hänzel & Partner**
**Möhlstrasse 37**
**D-8000 München 80(DE)**

(54) Random access memory device.

(57) This RAM has a plurality of memory cells (M11 to MLN), first bit lines (B1-1 to B1-N) which are connected to data terminals of these memory cells (M11 to MLN) second bit lines (B2-1 to B2-N) which are connected to complement data terminals of the memory cells (M11 to MLN), a first circuit (36, Q1-1 to Q1-N, Q2-1 to Q2-N) to precharge the first and second bit lines (B1-1 to B1-N, B2-1 to B2-N) in response to the updating of an address signal (A), and a second circuit (42, 46-1 to 46-N) to discharge either one of the first bit lines (B1-1 to B1-N) and the second bit lines (B2-1 to B2-N) in accordance with the data and in response to a write instruction (WI). Particularly, in the RAM the first circuit has a signal generator (36) to generate a signal indicative of the completion of the precharge and the second circuit has a gate circuit (38, 40) to generate a signal corresponding to the write instruction (WI) and an output signal of the signal generator (36).

./...

FIG. 3

- 1 -

Random access memory device

The present invention generally relates to a semiconductor memory device and, more particularly, to a random access memory (RAM) device having bit lines which are precharged whenever data is read and written.

Recently, a semiconductor memory device having very high integration has been developed. In the development of such a memory device, high operating speed and reduced electrical power consumption are important subjects.

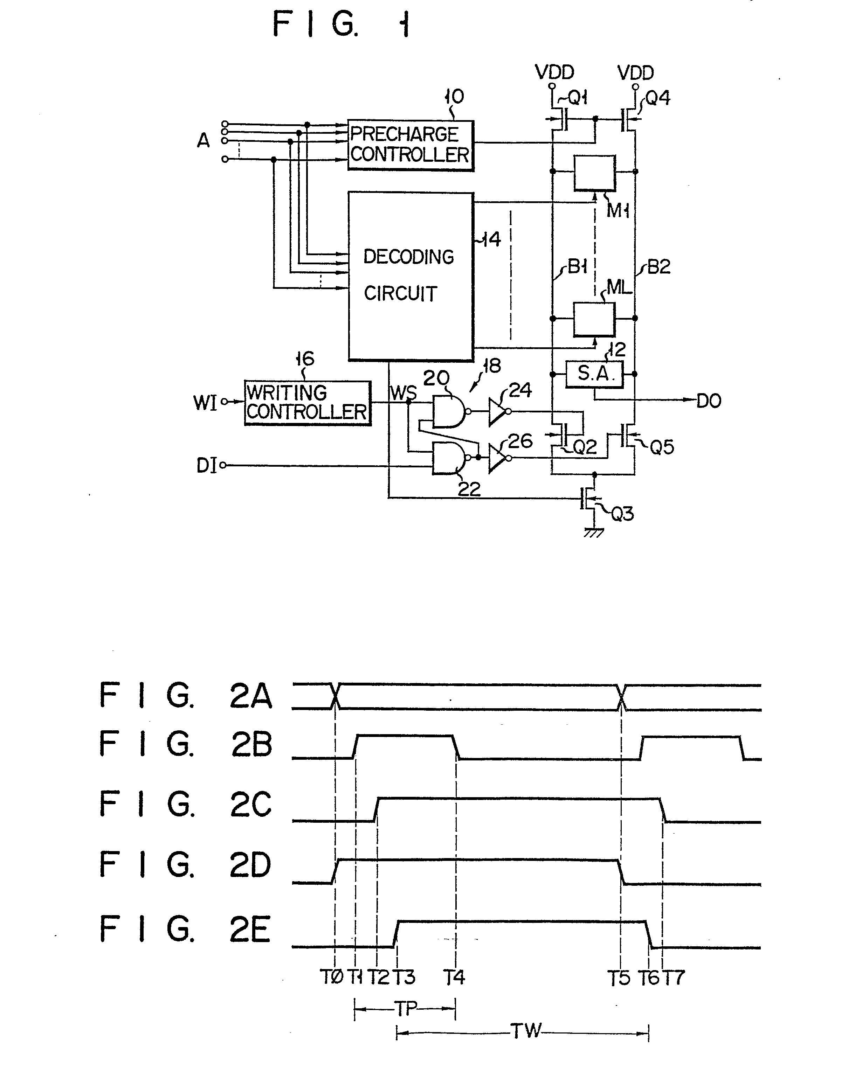

For example, there has already been known a static RAM using a transition detector in order to precharge the bit line as fast as possible after the address signal was updated. In this RAM, a plurality of memory cells are arranged like a matrix on the semiconductor chip. Fig. 1 shows memory cells M1 to ML of the same column in this matrix together with a data writing circuit. This RAM has a bit line B1 connected to data terminals of the memory cells M1 to ML and a bit line B2 connected to complement data terminals of the memory cells M1 to ML. The bit line B1 is connected through an n-channel MOS transistor Q1 to a power source terminal VDD, and at the same time, it is also grounded through n-channel MOS transistors Q2 and Q3 in this order. On the other hand, the bit line B2 is connected through an n-channel MOS transistor Q4 to the power source terminal VDD and is also grounded through n-channel MOS transistors Q5 and Q3 in this order. The conductions of the MOS transistors Q1 and Q4 are controlled by a precharge controller 10. The precharge controller 10 has a transition detector for detecting the updating of an address signal and a signal generator for supplying drive signal to the MOS transistors Q1 and Q4 for a predetermined period in response to an output signal of this transition detector. The bit lines B1 and B2 are precharged during the time period in which the MOS transistors Q1 and Q4 are kept conductive due to the drive signal. The voltage difference between the bit lines B1 and B2 is detected by a sense amplifier 12 for reading data. In addition, this RAM has a decoding circuit 14 to decode an address signal A. The decoding circuit 14 includes a row decoder and a column decoder. One of the memory cells M1 to ML and the MOS transistor Q3 receive drive signals which are simultaneously generated from the row and column decoders in accordance with a particular address signal. A write instruction WI is supplied to a writing controller 16. The writing controller 16 supplies a write permitting signal WS, which is maintained at a high level for a predetermined period, to a data setting circuit 18 in response to the write instruction WI. The data setting circuit 18 is provided to control the conductions of the MOS transistors Q2 and Q5 and includes NAND gates 20 and 22 and inverters 24 and 26. The data setting circuit 18 maintains the MOS transistors Q2 and Q5 in a non-conductive state during the period in which no write permitting signal is supplied from the writing controller 16. When the write permitting signal is supplied, the data setting circuit 18 operates so as to selectively make one of the MOS transistors Q2 and Q5 conductive and to make the other non-conductive in accordance with data DI for writing.

The operation to write data in, e.g., the memory cell Ml shown in Fig. 1 will now be described with reference to Figs. 2A to 2E. The write instruction WI, address signal A and writing data DI are supplied to the RAM from the outside. Upon writing the data, the write instruction WI is ordinarily set so as to rise simultaneously with the updating of the address signal A or after this updating. For instance, it is assumed that the address signal A is updated at time $T\phi$ as shown in Fig. 2A, and the write instruction WI is simultaneously supplied as shown in Fig. 2D. Then, in response to the updating of the address signal A, the precharge controller 10 immediately supplies a drive signal as shown in Fig. 2B to the MOS transistors Q1 and Q4 during the time period from time T1 to time T4. A drive signal as shown in Fig. 2C is supplied to the memory cell Ml from the row decoder of the decoding circuit 14 at time T2 while the bit lines B1 and B2 are respectively precharged through the MOS transistors Q1 and Q4. At this time, the MOS transistor Q3 is made conductive due to the column decoder of the decoding circuit 14. In response to the write instruction WI, the writing controller 16 generates the write permitting signal WS at a high level at time T3 as shown in Fig. 2E and supplies this signal WS to the data setting circuit 18. The data setting circuit 18 holds both MOS transistors Q2 and Q5 non-conductive during the time in which the signal WS is not supplied. When this signal WS is supplied, the data setting circuit 18 selectively renders either one of the MOS transistors Q2 and Q5 conductive in accordance with the data DI. Due to this, in association with the completion of a precharge period TP of the bit lines B1 and B2 at time T4, either one of the bit lines B1 and B2 is set at a predetermined voltage, and the other is set at a ground voltage. The memory cell Ml stores the voltages of the bit lines B1 and B2 as the data. The data DI is determined after time T0, and this determined value is maintained by the time period in which the data is correctly written. The writing of the data ends at time T6. A data writing period TW is the time required for the memory cell M1 to store the data. As shown in Fig. 2A, the address signal A is again updated at time T5 and the write instruction WI simultaneously trails as shown in Fig. 2D. As shown in Fig. 2E, the writing controller 16 stops the generation of the write permitting signal WS at time T6. This stop timing is set before the time when the decoding circuit 14 interrupts the drive signal shown in Fig. 2C being sent to the memory cell M1 in response to the address signal A which has been updated at time T5.

The write permitting signal WS has to be generated while the particular memory cell, for example, the memory cell M1, is driven and has to disappear before another memory cell which is driven next is selected. Therefore, the response time of the writing controller 16 and the time period for the generation of the write permitting signal WS are ordinarily set using a delay circuit such that the leading time is slow and the trailing time is fast.

In this RAM, when the signal WS is inputted simultaneously with or immediately after the change of the address signal A, the data writing period TW overlaps for the precharge period TP. In this overlap period (from time T3 to time T4), a great amount of direct current flows from the power source terminal VDD to the ground through either one of the path formed of the MOS transistor Q1, bit line B1, and MOS transistors Q2 and Q3 and the path formed of the MOS transistor Q4, bit line B2, and MOS transistors Q5 and Q3. When this direct current flows, the potential of the power source terminal VDD drops to a value lower than the predetermined value, so that the noises will have occurred on the power source line and other bit lines B1-2 to B1-N and B2-2 to B2-N. Further, at the time when the precharge period ends, due to the voltage decrease of the power source terminal VDD, the bit line of the path through which no direct current flows may be at a voltage lower than a predetermined precharge voltage. This causes the RAM to store erroneous data in the memory cell. In the case where the sense amplifier 12 belongs to the type of latching the bit line voltage, there is a high possibility such that readout data DO will have been changed to an erroneous value due to the foregoing voltage decrease of the bit line.

It is an object of the present invention to provide a random access memory device in which the overlap of the precharge period of the bit line and the data writing period is prevented and which operates at a high speed with high reliability.

According to the present invention, there is provided a random access memory device comprising: a bit line; a plurality of memory cells connected to this bit line; a decoding circuit to designate in accordance with an address signal the memory cell in which data should be stored; a precharge control circuit to precharge the bit line in response to the updating of the address signal for a predetermined time period and to generate an end signal indicative of the completion of this predetermined period; a data setting circuit to set the voltage in accordance with the data to the bit line in response to a write permitting signal; and a write control circuit to supply the write permitting signal to the data setting circuit in response to a write instruction and to the end signal.

According to the present invention, the write permitting signal is generated by the write control circuit in response to the end signal and to the write instruction. Due to this, the bit line is precharged, and thereafter this bit line is, for example, discharged in accordance with the data. Namely, the bit line is not discharged, while it is precharged, so that the malfunction of this RAM due to the voltage decrease of the bit line is prevented.

This invention can be more fully understood from the following detailed description when taken in conjunction with the accompanying drawings, in which:

Fig. 1 is a diagram partially showing a conventional random access memory in which a transition detector is used to detect the updating of an address signal;

Figs. 2A to 2E are time charts for explaining the writing operation in the random access memory of Fig. 1;

Fig. 3 shows a random access memory according to one embodiment of the present invention; and

Figs. 4A to 4E are time charts for explaining the writing operation of the random access memory of Fig. 3.

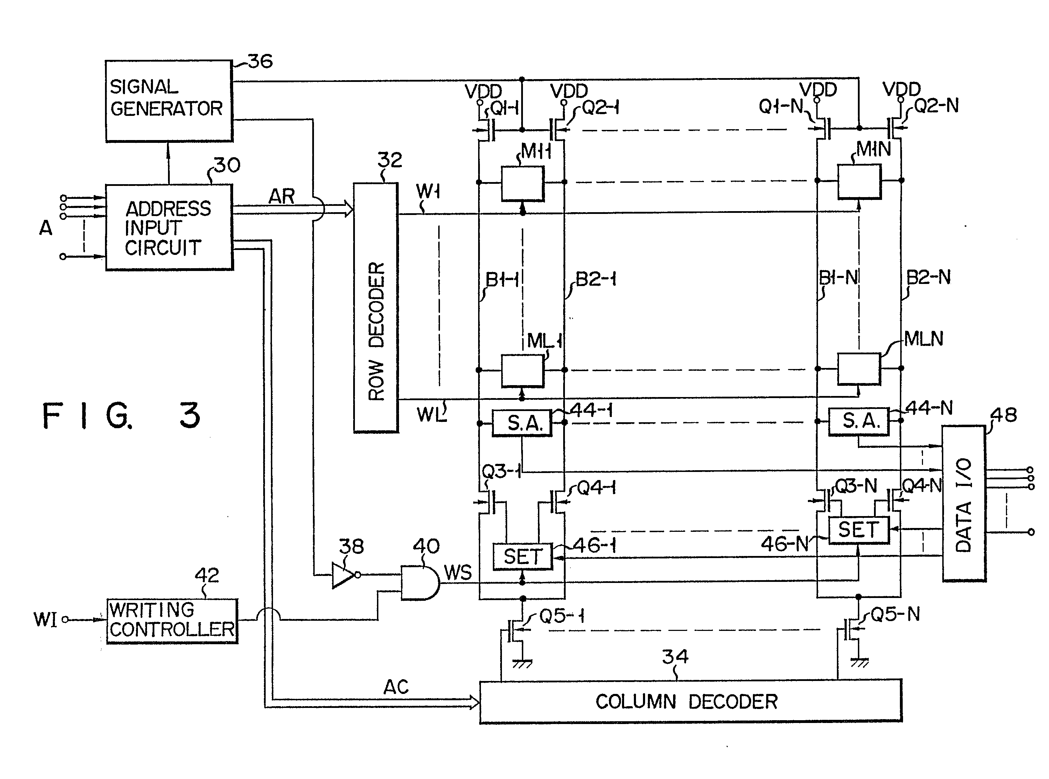

A random access memory (RAM) of one embodiment of the present invention will now be described with reference to Fig. 3. The RAM of Fig. 3 has, for example, (L × N) memory cells M11 to M1N; ...; ML1 to MLN which are formed like a matrix on a semiconductor chip. Word lines W1 to WL are formed along the rows of the memory cells M11 to MLN. First bit lines B1-1 to B1-N and second bit lines B2-1 to B2-N are formed along the columns of the memory cells. The memory cells of the same row, for instance, the memory cells M11 to M1N are selected through the word line W1. The data terminals of the memory cells of the same column, e.g., of the memory cells M11 to ML1, are connected to the bit line B1-1, while the complement data terminals of the memory cells M11 to ML1 are connected to the bit line B2-1. The data terminals and complement data terminals of the memory cells of each of the other columns are also connected to the corresponding bit lines in a similar manner as above. This RAM further has n-channel MOS transistors Q1-1 to Q1-N, Q2-1 to Q2-N, Q3-1 to Q3-N, Q4-1 to Q4-N, and Q5-1 to Q5-N in correspondence to the columns of the memory cells M11 to MLN. For example, the bit line B1-1 is connected through the current path of the MOS transistor Q1-1 to the power source terminal VDD, and at the same time, it is grounded through the current paths of the MOS transistors Q3-1 and Q5-1 in this order. The bit line B2-1 is connected through the current path of the MOS transistor Q2-1 to the power source terminal VDD and is grounded through the MOS transistors Q4-1 and Q5-1 in this order. The other transistors are also connected to the corresponding bit lines in a similar manner as above. The memory cells of the same column, e.g., the memory cells M11 to ML1 are selected due to the conduction of the MOS transistor Q5-1.

An address input circuit 30 includes buffers to receive the address signal A and a transition detector to detect the updating of the address signal A. The address signal A is divided into a row address signal AR and a column address signal AC by the address input circuit 30, and these signals are supplied to a row decoder 32 and a column decoder 34, respectively. The row decoder 32 selectively supplies a drive signal to one of the word lines W1 to WL in accordance with the row address signal AR. The column decoder 34 selectively supplies a drive signal to a predetermined number of memory cells among the MOS transistors Q5-1 to Q5-N in accordance with the column address signal AC. The conductions of the MOS transistors Q1-1 to Q1-N and Q2-1 to Q2-N are controlled by an output signal from a first output terminal of a signal generator 36. The signal generator 36 generates high-level signals from first and second output terminals for a predetermined time period in response to a detection signal supplied from the transition detector in the address input circuit 30. After the elapse of this predetermined period, the signal generator 36 generates low-level signals from the first and second output terminals. The bit lines B1-1

to B1-N and B2-1 to B2-N are precharged during the period in which the MOS transistors Q1-1 to Q1-N and Q2-1 to Q2-N are kept conductive due to the high-level signal supplied from the first terminal of the signal generator 36. The second output terminal of the signal generator 36 is connected to a first input terminal of an AND gate 40 through an inverter 38. The write instruction WI is supplied to a writing controller 42. The writing controller 42 supplies a high-level signal to a second input terminal of the AND gate 40 for a predetermined time period in response to the write instruction WI. The AND gate 40 generates the write permitting signal WS in response to the input signals at high level.

This RAM has sense amplifiers 44-1 to 44-N and data setting circuits 46-1 to 46-N in correspondence to the columns of the memory cells and also has a data input/output circuit 48. The data input/output circuit 48 includes input buffers and output buffers, and the write data is supplied through these input buffers to the corresponding data setting circuits. The data setting operations of the data setting circuits 46-1 to 46-N are controlled by the AND gate 40. Each data setting circuit, e.g., the data setting circuit 46-1, holds the MOS transistors Q3-1 and Q4-1 non-conductive irrespective of the write data during the period in which a low-level signal is supplied from the AND gate 40. When a high-level signal is supplied as the write permitting signal WS, the data setting circuit 46-1 renders either one of the MOS transistors Q3-1 and Q4-1 conductive in accordance with the write data. For instance, when the data is "1", the low-level signal and high-level signal are respectively supplied to the gates of the MOS transistors Q3-1 and Q4-1. On the contrary, when the data is "0", the high-level signal and low-level signal are respectively supplied to the gates of the MOS transistors Q3-1 and Q4-1. The other MOS transistors Q3-2 to Q3-N and Q4-2 to Q4-N are also controlled by the corresponding data setting circuits 46-2 to 46-N in a similar manner as above. The sense amplifiers 44-1 to 44-N respectively supply output signals corresponding to the voltage differences between the first and second bit lines B1-1 and B2-1; ..., B1-N and B2-N as readout data to output buffers in the data input/output circuit 48.

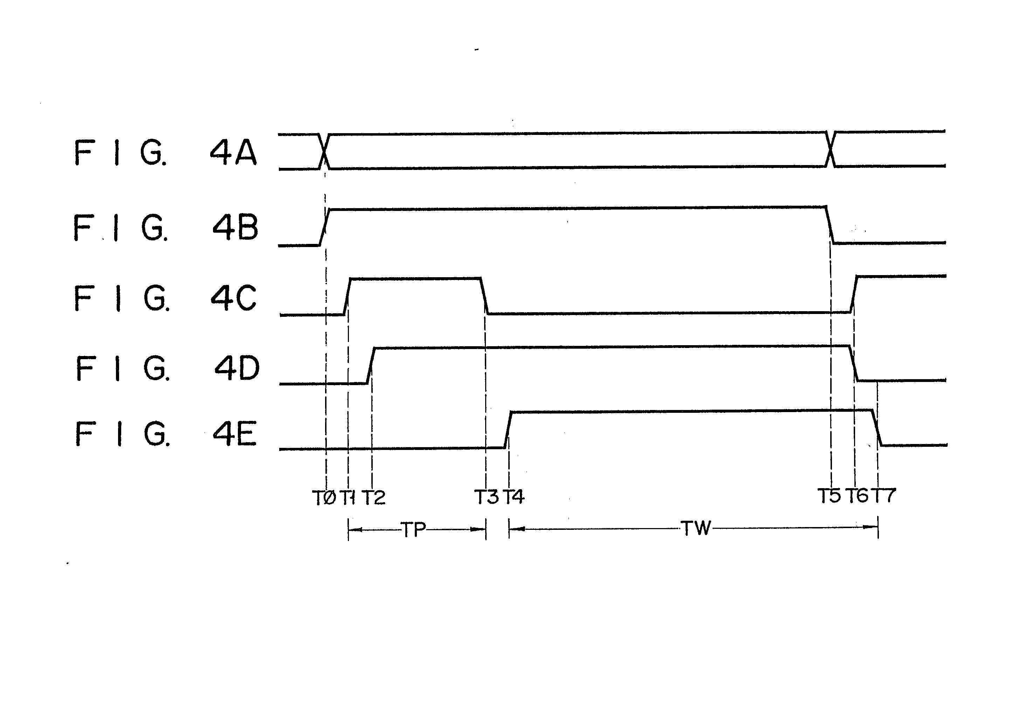

Next, the writing operation of the above-described RAM will be explained with reference to Figs. 4A to 4E. For example, when the address signal A is updated at time Tφ as shown in Fig. 4A and the write instruction WI is supplied as shown in Fig. 4B, the transition detector in the address input circuit 30 supplies a detection signal to the signal generator 36. In response to this detection signal, the signal generator 36 supplies a high-level signal as shown in Fig. 4C to the MOS transistors Q1-1 to Q1-N and Q2-1 to Q2-N for the period from time T1 to time T3. During this period, the bit lines B1-1 to B1-N and B2-1 to B2-N are precharged. After the start of precharge, the row decoder 32 supplies a drive signal to the memory cells of the row corresponding to the row address signal AR, while the column decoder 34 makes predetermined MOS transistors among the MOS transistors Q5-1 to Q5-N conductive in accordance with the column address signal AC. Thereafter, the writing controller 42 generates a high-level signal after time T2 as shown in Fig. 4D. When the signal generator 36 trails at time T3, as shown in Fig. 4C, the AND gate 40 supplies a high-level signal, as shown in Fig. 4E, as a write permitting signal WS to the data setting circuits 46-1 to 46-N in response to this trailing edge. After time T4, for example, either one of the MOS transistors Q3-1 and Q4-1 is made conductive due to the data setting circuit 46-1. Assuming that the MOS transistor Q5-1 is kept conductive due to the column decoder 34, one of the bit lines B1

and B2 precharged until time T3 is discharged. The memory cell selected by the row decoder 32 stores the voltages of the bit lines B1 and B2 as the data. As shown in Fig. 4A, when the address signal A is updated at time T5, the signal generator 36 again generates a high-level signal to precharge after time T6, as shown in Fig. 4C. The output signal of the writing controller 42 also trails at time T5, as shown in Fig. 4D. In response to the leading edge of the output signal of the signal generator 36 or to the trailing edge of the output signal of the writing controller 42, the AND gate 40 generates a low-level signal at time T7, as shown in Fig. 4E. Namely, the write permitting signal WS is interrupted.

As described above, in the RAM of this embodiment, the AND gate 40 generates the write permitting signal WS with respect to the output signal of the signal generator 36 and to the output signal of the writing controller 42. That is, the precharge period TP of the bit lines and the writing period TW of the data are assigned to the different time bands. Therefore, a large current does not flow from the power source terminal VDD to the ground through the bit lines B1-1 to B1-N and B2-1 to B2-N. Thus, the malfunction due to the voltage decrease of the power source terminal VDD does not occur in this RAM, and the noise on the power source line is also sufficiently reduced.

Claims:

1. A random access memory device comprising: a plurality of bit lines (B1-1 to B1-N, B2-1 to B2-N); a plurality of memory cells (M11 to MLN) connected to said bit lines; decoding means (32, 34, Q5-1 to Q5-N) which decodes an address signal to designate the memory cell in which data should be stored; precharge control means (Q1-1 to Q1-N, Q2-1 to Q2-N, 30) which precharges said bit lines (B1-1 to B1-N, B2-1 to B2-N) for a predetermined time period in response to the updating of said address signal; data setting means (46-1 to 46-N) which sets the voltages corresponding to the data to said bit lines (B1-1 to B1-N, B2-1 to B2-N) in response to a write permitting signal; and write control means (42) for generating said write permitting signal in response to a write instruction, characterized in that said precharge control means has a signal generator (36) to generate an end signal indicative of the completion of said predetermined time interval and further said write control means has a gate circuit (38, 40) to generate said write permitting signal in response to said end signal and said write instruction.

2. A random access memory device according to claim 1, characterized in that said precharge control means has a transition detector (30) to detect the updating of said address signal, a first signal generator (36) to generate a drive signal for a predetermined time period in response to an output signal of said transition detector, and a precharge circuit (Q1-1 to Q1-N, Q2-1 to Q2-N) to precharge said bit lines by said drive signal.

3. A random access memory device according to claim 2, characterized in that said write control means has a gate circuit (39, 40) connected to said first signal generator (36) in said precharge control means and which outputs said write instruction as said write permitting signal for the time period in which the drive signal is not supplied from said first signal generator.

4. A random access memory device according to claim 2, characterized in that said write control means has a second signal generator (42) to generate an output signal for a predetermined time interval in response to said write instruction, and a gate circuit (38, 40) which is connected to said first signal generator (36) in said precharge control means and to said second signal generator (42) and which outputs the signal from said second signal generator (42) as the write permitting signal during the time interval when the drive signal is not supplied from said first signal generator.

5. A random access memory device according to claim 4, characterized in that said gate circuit includes an inverter (38) to invert the output signal of said first signal generator and an AND gate (40) to generate an output signal corresponding to the output signals of said inverter and said second signal generator.

6. A random access memory device according to claim 5, characterized in that said precharge circuit in said precharge control means includes first and second switching elements (Q1-1, Q2-1) which are made conductive in response to the drive signal from said first signal generator, and said plurality of bit lines include a first bit line (B1-1) which is connected to a power source terminal through said first switching means and a second bit line (B2-1) which is connected to said power source terminal through said second switching means.

0158028

F I G. 1

F I G. 2A
F I G. 2B
F I G. 2C
F I G. 2D
F I G. 2E

F I G. 3

F I G. 4A

F I G. 4B

F I G. 4C

F I G. 4D

F I G. 4E

TØ T1 T2    T3 T4    T5 T6 T7

|←—TP—→|←————————TW————————→|

0158028